(19) Europäisches Patentamt / European Patent Office / Office européen des brevets

(11) **EP 4 507 141 B1**

(12) **FASCICULE DE BREVET EUROPEEN**

(45) Date de publication et mention
de la délivrance du brevet:
**11.02.2026 Bulletin 2026/07**

(21) Numéro de dépôt: **24192705.2**

(22) Date de dépôt: **02.08.2024**

(51) Classification Internationale des Brevets (IPC):
*H01S 5/02* *(2006.01)* *H01S 5/12* *(2021.01)*
*H01S 5/40* *(2006.01)* *H01S 5/343* *(2006.01)*

(52) Classification Coopérative des Brevets (CPC):
**H01S 5/4087; H01S 5/0206; H01S 5/3211;**
H01S 5/12; H01S 5/3402; H01S 5/34306

(54) **PROCÉDÉ DE RÉALISATION DE DISPOSITIFS OPTOÉLECTRONIQUES**

VERFAHREN ZUR HERSTELLUNG OPTOELEKTRONISCHER VORRICHTUNGEN

METHOD FOR PRODUCING OPTOELECTRONIC DEVICES

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **10.08.2023 FR 2308645**

(43) Date de publication de la demande:
**12.02.2025 Bulletin 2025/07**

(73) Titulaire: **Commissariat à l'Energie Atomique et
aux Energies
Alternatives
75015 Paris (FR)**

(72) Inventeurs:
• **FOURNIER, Maryse**
**38054 GRENOBLE Cedex 09 (FR)**
• **BEN BAKIR, Badhise**
**38054 GRENOBLE Cedex 09 (FR)**
• **NICOLETTI, Sergio**
**38054 GRENOBLE Cedex 09 (FR)**

(74) Mandataire: **Hautier IP
20, rue de la Liberté
06000 Nice (FR)**

(56) Documents cités:
WO-A1-2007/032268    US-A1- 2005 030 997
US-B2- 6 546 035      US-B2- 7 433 380

**Description**

**DOMAINE TECHNIQUE**

La présente invention concerne le domaine de l'optoélectronique. Elle peut être mise en œuvre pour la réalisation de composants émetteurs de lumière, notamment dans le domaine du moyen infrarouge (MIR). Elle trouve pour application particulièrement avantageuse la réalisation de sources laser à cascade quantique émettant à différentes longueurs d'onde.

**ETAT DE LA TECHNIQUE**

Le domaine du moyen infrarouge (MIR) présente une gamme spectrale relativement étendue, couvrant notamment des longueurs d'onde comprises entre 4 µm et 10 µm. La fabrication de sources de lumière MIR monochromatiques sur cette gamme spectrale requiert généralement une ligne de fabrication dédiée pour chaque longueur d'onde. Cela permet d'ajuster la structure de chaque source MIR pour optimiser le fonctionnement de ces sources. Une source MIR émettant à 4 µm est ainsi structurellement différente d'une source MIR émettant à 10 µm. Une source MIR comprend typiquement un empilement de couches optiquement actives à base de matériaux III-V, destinées notamment à émettre, propager et/ou confiner un rayonnement lumineux. En fonction de la longueur d'onde d'émission souhaitée, les épaisseurs de ces couches peuvent être très différentes d'une source MIR à une autre.

Les procédés de fabrication de ces sources MIR sont donc complexes et coûteux à mettre en œuvre. Un enjeu consiste à simplifier les procédés de fabrication de ces sources MIR pour développer une filière technologique compatible avec l'industrie microélectronique pour une large gamme de longueur d'onde.

Un objectif de la présente invention est de répondre au moins en partie à ce besoin.

Par ailleurs US2005/030997 décrit une pluralité de dispositifs optoélectroniques formés sur un même substrat, fonctionnant à une pluralité de longueurs d'onde et présentant une différence d'épaisseur totale des couches fonctionnelles dépendant de la différence en longueur d'onde entre les dispositifs.

En particulier, un objet de la présente invention est un procédé de fabrication de dispositifs optoélectroniques fonctionnant à différentes longueurs d'onde, qui est moins coûteux et/ou qui présente une meilleure compatibilité industrielle vis-à-vis des procédés existants. Un tel procédé est avantageusement mis en œuvre pour réaliser différents dispositifs optoélectroniques fonctionnant à des longueurs d'onde différentes.

Les autres objets, caractéristiques et avantages de la présente invention apparaîtront à l'examen de la description suivante et des dessins d'accompagnement. Il est entendu que d'autres avantages peuvent être incorporés.

**RESUME**

Pour atteindre cet objectif, selon un mode de réalisation on prévoit un procédé de fabrication d'au moins un premier dispositif optoélectronique fonctionnant à une première longueur d'onde λ1 et un deuxième dispositif optoélectronique fonctionnant à une deuxième longueur d'onde λ2 > λ1.

Le premier dispositif optoélectronique comprend un premier empilement selon une direction z sur un premier substrat et le premier empilement comprend une première couche d'encapsulation inférieure d'épaisseur e10 selon la direction z et une pluralité de premières couches d'épaisseur e1i (i = 1...m) selon la direction z. Le deuxième dispositif optoélectronique comprend un deuxième empilement selon la direction z sur un deuxième substrat et le deuxième empilement comprend une deuxième couche d'encapsulation inférieure d'épaisseur e20 selon la direction z et une pluralité de deuxièmes couches d'épaisseur e2i (i = 1... n) selon la direction z. Les deuxièmes couches d'épaisseur e2i présentent des fonctions optiques semblables à celles des premières couches d'épaisseur e1i.

Avantageusement, le procédé comprend les étapes suivantes :

- Former le deuxième empilement sur le deuxième substrat, en dimensionnant les épaisseurs e20 et e2i en fonction de la deuxième longueur d'onde λ2,
- Former le premier empilement sur le premier substrat, en dimensionnant les épaisseurs e10 et e1i selon :

$$e1i = e2i.\frac{\lambda1}{\lambda2}.\alpha i \text{ avec } 0{,}7 \leq \alpha i \leq 1{,}3$$

$$e10 = e20 + \sum_{i=1}^{n} e2i - \sum_{i=1}^{n} e1i$$

- Réaliser au moins une même étape technologique supplémentaire sur les premier et deuxième empilements, par exemple une gravure des premier et deuxième empilements selon une même profondeur selon z, de façon à obtenir les premier et deuxième dispositifs optoélectroniques.

Dans ce procédé, les premier et deuxième empilements sont dimensionnés de façon à présenter avantageusement une même hauteur. Les premier et deuxième empilements peuvent ainsi être avantageusement structurés par une ou plusieurs étapes technologiques communes. Des motifs de gravure peuvent être définis via des paramètres de photolithographie communs pour les deux empilements (épaisseur des résines, plan focal etc). Les premier et deuxième empilements peuvent ensuite être gravés par un même procédé de gravure. La passivation et la formation ultérieure de contacts peuvent également être réalisées de la même façon sur les deux empilements.

Typiquement, les étapes de formation des premier et deuxième empilements se font séparément. Le premier empilement peut être formé par épitaxie sur un substrat donneur avant d'être reporté sur le premier substrat. Le deuxième empilement peut être formé par épitaxie sur un autre substrat donneur avant d'être reporté sur le deuxième substrat. Après formation des premier et deuxième empilements, un certain nombre d'étapes technologiques communes peut être effectué sur ces deux empilements. Cela permet de concevoir une filière technologique commune pour la réalisation des premier et deuxième dispositifs optoélectroniques. Les premier et deuxième empilements peuvent avantageusement faire partie d'un même lot technologique. Selon un exemple, le premier empilement sur le premier substrat forme une première plaque de ce lot technologique et le deuxième empilement sur le deuxième substrat forme une deuxième plaque de ce lot technologique. Lorsqu'un équipement de l'industrie microélectronique reçoit un tel lot technologique, chaque plaque du lot technologique est traitée de la même façon par l'équipement. Le coût du procédé de réalisation des premier et deuxième dispositifs optoélectroniques est avantageusement diminué.

Selon un autre aspect de l'invention, on prévoit un système pour la fabrication d'au moins un premier dispositif optoélectronique fonctionnant à une première longueur d'onde $\lambda 1$ et un deuxième dispositif optoélectronique fonctionnant à une deuxième longueur d'onde $\lambda 2 > \lambda 1$. Le système comprend au moins un premier substrat portant un premier empilement selon une direction z et un deuxième substrat portant un deuxième empilement selon la direction z. Le premier empilement comprend une première couche d'encapsulation inférieure d'épaisseur e10 selon la direction z et une pluralité de premières couches d'épaisseur e1i (i = 1...n) selon la direction z. Le deuxième empilement comprend une deuxième couche d'encapsulation inférieure d'épaisseur e20 selon la direction z et une pluralité de deuxièmes couches d'épaisseur e2i (i = 1...n) selon la direction z. Les deuxièmes couches d'épaisseur e2i et les premières couches d'épaisseur e1i présentent des fonctions optiques semblables.

Avantageusement, les épaisseurs e10, e20 et e1i, e2i vérifient les relations suivantes :

$$e1i = e2i.\frac{\lambda 1}{\lambda 2}.\alpha i \text{ avec } 0{,}7 \leq \alpha i \leq 1.3$$

$$e10 = e20 + \sum_{i=1}^{n} e2i - \sum_{i=1}^{n} e1i$$

Les premier et deuxième empilements présentent ainsi sensiblement une même hauteur selon z.

Selon un exemple, ce système correspond à un lot technologique de l'industrie microélectronique, dans lequel le premier empilement sur le premier substrat forme une première plaque et le deuxième empilement sur le deuxième substrat forme une deuxième plaque. Un tel lot peut avantageusement être traité par des étapes technologiques communes, pour former des premier et deuxième dispositifs optoélectroniques différents. Les avantages mentionnés ci-dessus pour le procédé s'appliquent mutatis mutandis.

Selon un autre aspect de l'invention, on prévoit un dispositif comprenant un premier empilement et un deuxième empilement structuré sur un même support. Le premier empilement comprend une première couche d'encapsulation inférieure d'épaisseur e10 selon une direction z et au moins :

- une première couche active d'épaisseur e11 selon z, destinée à émettre ou recevoir un rayonnement présentant une première longueur d'onde $\lambda 1$, et
- une première couche d'encapsulation supérieure d'épaisseur e12 selon z.

Le deuxième empilement comprend une deuxième couche d'encapsulation inférieure d'épaisseur e20 selon la direction z et au moins :

- une deuxième couche active d'épaisseur e21 selon z, destinée à émettre ou recevoir un rayonnement présentant une deuxième longueur d'onde $\lambda 2 > \lambda 1$, et

- une deuxième couche d'encapsulation supérieure d'épaisseur e22 selon z.

Avantageusement, les épaisseurs e11, e12 vérifient les relations suivantes :

$$e12 = e22.\frac{\lambda 1}{\lambda 2}.\alpha 2 \text{ avec } 0.7 \leq \alpha 2 \leq 1.3$$

$$e11 = e21.\frac{\lambda 1}{\lambda 2}.\alpha 1 \text{ avec } 0.7 \leq \alpha 1 \leq 1.3$$

Avantageusement, les premier et deuxième empilements présentent sensiblement une même hauteur h selon z.

## BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :

La figure 1 illustre en coupe transverse un dispositif optoélectronique selon un mode de réalisation de la présente invention.
Les figures 2A, 2B illustrent respectivement en coupe transverse un deuxième et un premier dispositifs optoélectroniques selon un mode de réalisation de la présente invention.
Les figures 3A, 3B illustrent en coupe transverse une distribution simulée du rayonnement lumineux se propageant dans les deuxième et premier dispositifs optoélectroniques du mode de réalisation illustré aux figures 2A, 2B.
La figure 4 illustre une variation d'indice effectif et une variation de pertes optiques en fonction de la longueur d'onde, simulées pour différents dispositifs optoélectroniques émettant à différentes longueurs d'onde, selon un mode de réalisation de la présente invention.
La figure 5 illustre une variation de la constante de couplage normalisée en fonction de la longueur d'onde, simulée pour différents dispositifs optoélectroniques émettant à différentes longueurs d'onde, selon un mode de réalisation de la présente invention.
La figure 6 illustre un flux de procédé comprenant des étapes technologiques communes à la réalisation de différents dispositifs optoélectroniques émettant à différentes longueurs d'onde, selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches et portions, et les dimensions des motifs ne sont pas représentatives de la réalité.

## DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, l'au moins une même étape technologique du procédé de réalisation comprend une ou plusieurs étapes prises parmi : une gravure selon z d'un motif de guide d'onde, une passivation, une formation d'un contact électrique supérieur, une formation d'un contact électrique inférieur, une métallisation. Avantageusement toutes ces étapes peuvent être effectuées à la fois sur le premier empilement et sur le deuxième empilement. Une partie des procédés de réalisation des premier et deuxième dispositifs optoélectroniques est commune. Cela permet de concevoir une filière technologique en partie générique pour la réalisation de différents dispositifs optoélectroniques émettant à différentes longueurs d'onde, notamment dans le domaine du moyen infrarouge.
Selon un exemple, la pluralité de premières couches d'épaisseur e1i comprend au moins une première couche active d'épaisseur e11 selon z, destinée à émettre ou recevoir un rayonnement présentant la première longueur d'onde λ1, et une première couche d'encapsulation supérieure d'épaisseur e12 selon z. Selon un exemple, la pluralité de deuxièmes couches d'épaisseur e2i comprend au moins une deuxième couche active d'épaisseur e21 selon z, destinée à émettre ou recevoir un rayonnement présentant la deuxième longueur d'onde λ2, et une deuxième couche d'encapsulation supérieure d'épaisseur e22 selon z. Les premier et deuxième empilements comprennent des couches similaires ayant typiquement les mêmes fonctions. En particulier, chaque empilement comprend une couche active prise en sandwich entre des couches d'encapsulation. Les couches d'encapsulation peuvent également être qualifiées de « couches de revêtement » ou « couches de recouvrement » ; les couches d'encapsulation se traduisent typiquement par « cladding layers » en anglais.

Selon un exemple, la pluralité de premières couches d'épaisseur e1i comprend en outre une première couche inférieure de confinement optique d'épaisseur e13 intercalée entre la première couche d'encapsulation inférieure et la première couche active, et une première couche supérieure de confinement optique d'épaisseur e14 intercalée entre la première couche d'encapsulation supérieure et la première couche active. Selon un exemple, la pluralité de deuxièmes couches d'épaisseur e2i comprend en outre une deuxième couche inférieure de confinement optique d'épaisseur e23 intercalée entre la deuxième couche d'encapsulation inférieure et la deuxième couche active, et une deuxième couche supérieure de confinement optique d'épaisseur e24 intercalée entre la deuxième couche d'encapsulation supérieure et la deuxième couche active, avec :

$$e11 = e21.\frac{\lambda 1}{\lambda 2}.\alpha 1 \text{ avec } 0.7 \leq \alpha 1 \leq 1.3$$

$$e12 = e22.\frac{\lambda 1}{\lambda 2}.\alpha 2 \text{ avec } 0.7 \leq \alpha 2 \leq 1.3$$

$$e13 = e23.\frac{\lambda 1}{\lambda 2}.\alpha 3 \text{ avec } 0.7 \leq \alpha 3 \leq 1.3$$

$$e14 = e24.\frac{\lambda 1}{\lambda 2}.\alpha 4 \text{ avec } 0.7 \leq \alpha 4 \leq 1.3$$

$$e10 = e20 + e21 + e22 + e23 + e24 - (e12 + e11 + e13 + e14)$$

Selon un exemple, la pluralité de premières couches d'épaisseur e1i comprend en outre une première couche d'arrêt d'épaisseur e15 sous la première couche d'encapsulation inférieure. Selon un exemple, la pluralité de deuxièmes couches d'épaisseur e2i comprend en outre une deuxième couche d'arrêt d'épaisseur e25 sous la deuxième couche d'encapsulation inférieure. Selon un exemple, les épaisseurs e15, e25 sont telles que :

$$e15 = e25.\frac{\lambda 1}{\lambda 2}.\alpha 5 \text{ avec } 0.7 \leq \alpha 5 \leq 1.3$$

Cela permet d'éviter un phénomène d'onde évanescente par la première couche d'arrêt d'épaisseur e15.

Selon un exemple, les premier et deuxième empilements sont gravés selon une même profondeur h selon z pour former des première et deuxième structures en saillie, présentant respectivement une première largeur W1 selon une direction x et une première longueur L1 selon une direction y, et une deuxième largeur W2 selon la direction x et une deuxième longueur L2 selon la direction y, le procédé comprenant en outre, avant gravure des premier et deuxième empilements :

- Déterminer la deuxième largeur W2 et la deuxième longueur L2 en fonction de la deuxième longueur d'onde λ2,
- Déterminer la première largeur W1 et la première longueur L1 selon :

$$W1 = W2.\frac{\lambda 1}{\lambda 2}.\alpha_W \text{ avec } 0,7 \leq \alpha_W \leq 1,3$$

$$L1 = L2.\frac{\lambda 1}{\lambda 2}.\alpha_L \text{ avec } 0,7 \leq \alpha_L \leq 1,3$$

Selon un exemple, le procédé comprend en outre une première gravure configurée pour former un premier réseau présentant une première profondeur sur le premier empilement porté par le premier substrat, et indépendamment une deuxième gravure configurée pour former un deuxième réseau présentant une deuxième profondeur sur le deuxième empilement porté par le deuxième substrat. Cela permet typiquement de réaliser des lasers à contre-réaction distribuée, appelés DFB pour « Distributed FeedBack ». Les premier et deuxième réseaux sont spécifiques à la longueur d'onde. Ils sont typiquement formés par des première et deuxième gravures indépendantes.

Selon un exemple, les premières et deuxièmes longueurs d'onde λ1, λ2 sont choisies dans le domaine du moyen infrarouge entre 2 μm et 15 μm, de préférence entre 4 μm et 10 μm.

Selon un exemple, le premier empilement est bordé par des premières tranchées de profondeur h selon la direction z et forme une première structure en saillie, et le deuxième empilement est bordé par des deuxièmes tranchées de même profondeur h selon la direction z et forme une deuxième structure en saillie.

Selon un exemple, la pluralité de premières couches d'épaisseur e1i comprend au moins une première couche active d'épaisseur e11 selon z, destinée à émettre ou recevoir un rayonnement présentant la première longueur d'onde $\lambda 1$, et une première couche d'encapsulation supérieure d'épaisseur e12 selon z, et la pluralité de deuxièmes couches d'épaisseur e2i comprend au moins une deuxième couche active d'épaisseur e21 selon z, destinée à émettre ou recevoir un rayonnement présentant la deuxième longueur d'onde $\lambda 2$, et une deuxième couche d'encapsulation supérieure d'épaisseur e22 selon z, avec :

$$e12 = e22.\frac{\lambda 1}{\lambda 2}.\alpha 2 \text{ avec } 0,7 \leq \alpha 2 \leq 1,3$$

$$e11 = e21.\frac{\lambda 1}{\lambda 2}.\alpha 1 \text{ avec } 0,7 \leq \alpha 1 \leq 1,3$$

Selon un exemple, la première structure en saillie présente une première largeur W1 selon une direction x et une première longueur L1 selon une direction y, et la deuxième structure en saillie présente une deuxième largeur W2 selon la direction x et une deuxième longueur L2 selon la direction y, les première et deuxième largeurs W1, W2 et les première et deuxième longueurs L1, L2 vérifiant les relations suivantes :

$$W1 = W2.\frac{\lambda 1}{\lambda 2}.\alpha_W \text{ avec } 0,7 \leq \alpha_W \leq 1,3$$

$$L1 = L2.\frac{\lambda 1}{\lambda 2}.\alpha_L \text{ avec } 0,7 \leq \alpha_L \leq 1,3.$$

Selon un exemple, les premier et deuxième substrats sont à base de silicium et les premier et deuxième empilements sont à base de matériaux III-V, les premier et deuxième empilements comprenant respectivement des première et deuxième couches d'isolation optique configurées pour éviter un couplage optique aux longueurs d'onde $\lambda 1$ et $\lambda 2$ avec les premier et deuxième substrats.

Selon un exemple, les premier et deuxième dispositifs optoélectroniques correspondent à des premier et deuxième lasers à cascade quantique à contre-réaction distribuée.

Sauf incompatibilité, il est entendu que l'ensemble des caractéristiques optionnelles ci-dessus et/ou les variantes indiqués peuvent être combinées de façon à former un mode de réalisation qui n'est pas nécessairement illustré ou décrit. Un tel mode de réalisation n'est évidemment pas exclu de l'invention. Les caractéristiques d'un aspect de l'invention, par exemple le système, le dispositif ou le procédé, peuvent être adaptées *mutatis mutandis à* un autre aspect de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants. Ainsi, un substrat à base de silicium s'entend par exemple d'un substrat Si ou Si dopé, ou encore SiGe. Une couche à base d'InP s'entend par exemple d'une couche InP, InP dopée, ou des alliages d'InP. Une couche de passivation à base de nitrure de silicium SiN peut par exemple comprendre du nitrure de silicium non stœchiométrique (SixNy), ou du nitrure de silicium stœchiométrique (Si3N4).

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

**EP 4 507 141 B1**

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent », « intercalé », « au-dessus », « en-dessous » se réfèrent à des positions prises selon la direction z. Cette liste de termes n'est pas exhaustive. D'autres termes relatifs pourront être facilement précisés au besoin, en se référant aux dessins d'accompagnement.

Les termes « vertical », « verticalement » se réfèrent à une direction selon z. Les termes « horizontal », « horizontalement », « latéral », « latéralement » se réfèrent à une direction dans le plan xy. Sauf mention explicite, l'épaisseur, la hauteur et la profondeur sont mesurées selon z.

Un élément situé « à l'aplomb » ou « au droit d' » un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

La présente invention trouve pour domaine préférentiel d'application une plateforme évolutive de fabrication de lasers à cascade quantique QCL dans le domaine spectral du moyen infrarouge (MIR).

Les dispositifs optoélectroniques selon la présente invention émettent typiquement des rayonnements lumineux monochromatiques ou quasi-monochromatiques, présentant chacun une longueur d'onde principale. La longueur d'onde principale est l'unique longueur d'onde émise par un laser monochromatique, ou la longueur d'onde principalement émise par un laser quasi-monochromatique.

Dans le cadre de la présente invention, le rayonnement lumineux est typiquement guidé et/ou confiné de façon à assurer sa propagation selon une direction principale de propagation, prise selon l'axe x dans les dessins d'accompagnement. Le rayonnement lumineux est de préférence cohérent et monochromatique. Le rayonnement lumineux se propage de préférence selon un unique mode de propagation optique, typiquement le mode optique fondamental transverse électrique (TE00) ou transverse magnétique (TM00).

Pour guider et/ou confiner le rayonnement lumineux, les premier et deuxième empilements sont typiquement structurés pour former des première et deuxième structures en saillie, respectivement. Dans la suite, la première structure en saillie correspond typiquement à une partie du premier empilement. La deuxième structure en saillie correspond typiquement à une partie du deuxième empilement.

Les termes « sensiblement », « environ », « de l'ordre de » signifient « à 10% près » ou, lorsqu'il s'agit d'une orientation angulaire, « à 10° près » et de préférence « à 5° près ». Ainsi, une direction sensiblement normale à un plan signifie une direction présentant un angle de $90 \pm 10°$ par rapport au plan.

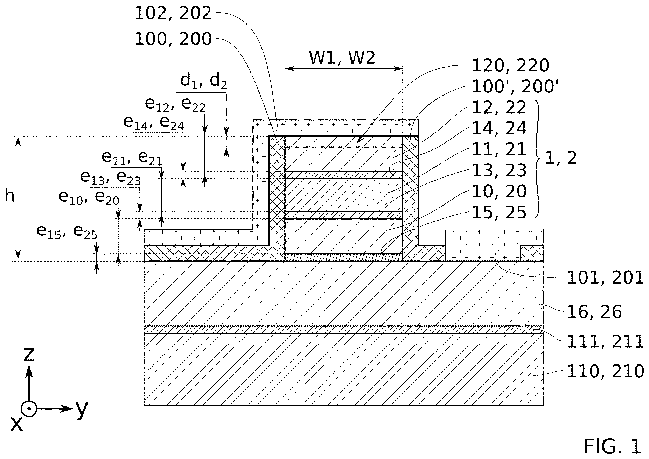

La figure 1 illustre de façon générique un dispositif optoélectronique selon l'invention. Les références numériques commençant par le chiffre 1 se rapportent à un premier dispositif optoélectronique. Les références numériques commençant par le chiffre 2 se rapportent à un deuxième dispositif optoélectronique. Les premier et deuxième dispositifs optoélectroniques comprennent typiquement les mêmes éléments. Il existe une correspondance de fonction entre deux éléments de même nature. Les références alphanumériques commençant par une lettre suivie du chiffre 1 se rapportent à des dimensions du premier dispositif optoélectronique. Les références alphanumériques commençant par une lettre suivie du chiffre 2 se rapportent à des dimensions du deuxième dispositif optoélectronique. Les dimensions des éléments du premier dispositif optoélectronique sont typiquement différentes de celles des éléments du deuxième dispositif optoélectronique. Le premier dispositif optoélectronique est configuré pour fonctionner à une première longueur d'onde $\lambda_1$. Le deuxième dispositif optoélectronique est configuré pour fonctionner à une deuxième longueur d'onde $\lambda_2$.

Le premier dispositif optoélectronique comprend typiquement, en empilement selon z :

- Un premier substrat 110, de préférence à base de silicium.
- Une première couche de collage 111, par exemple à base de SiO2.
- Une première couche d'isolation optique 16, typiquement à base d'InP.
- Une première couche d'arrêt de gravure 15 d'épaisseur $e_{15}$, par exemple à base d'InGaAs.
- Une première couche d'encapsulation inférieure 10 d'épaisseur $e_{10}$, par exemple à base d'InP.
- Une première couche inférieure de confinement optique 13 d'épaisseur $e_{13}$, par exemple à base d'InGaAs.
- Une première couche active 11 d'épaisseur $e_{11}$, comprenant par exemple des puits quantiques multiples à base de ternaires AlInAs, GaInAs ou de quaternaires de type GaInAsP ou AlGaInAs. Cette première couche active 11 est de préférence configurée pour émettre un premier rayonnement lumineux de longueur d'onde $\lambda_1$.

7

- Une première couche supérieure de confinement optique 14 d'épaisseur $e_{14}$, par exemple à base d'InGaAs.
- Une première couche d'encapsulation supérieure 12 d'épaisseur $e_{12}$, par exemple à base d'InP. Selon une possibilité, la première couche d'encapsulation supérieure 12 peut être structurée sous forme de réseau 120. Un tel réseau 120 se présente typiquement, de façon connue, sous forme de tranchées régulièrement espacées selon x. Les tranchées du réseau 120 présentent une profondeur $d_1$ selon z et sont distribuées selon un pas de réseau $p_1$ selon x. La profondeur $d_1$ et le pas de réseau $p_1$ dépendent de la longueur d'onde $\lambda_1$.

L'empilement des couches 16, 15, 10, 13, 11, 14, 12 forme un premier empilement. Ce premier empilement est de préférence à base de matériaux III-V. Il peut être formé par épitaxie sur un substrat donneur, par exemple à base d'InP, puis éventuellement reporté sur le premier substrat 110, par exemple à base de silicium. Une première couche de collage 111, par exemple à base d'oxyde de silicium, peut ainsi être intercalée entre le premier substrat 110 et le premier empilement. Lors de l'épitaxie, l'empilement se présente typiquement sous forme de couches planaires s'étendant sur toute la surface du substrat donneur. Cet empilement est ensuite structuré afin de réaliser le premier dispositif optoélectronique.

En particulier, l'empilement de couches 16, 15, 10, 13, 11, 14, 12 est au moins en partie gravé selon z de manière à former une première structure 1 en saillie de la couche d'isolation optique 16. Cette première structure 1 en saillie permet notamment de confiner et/ou guider le premier rayonnement lumineux de longueur d'onde $\lambda_1$ émis par la première couche active 11. Dans cet exemple, le premier rayonnement lumineux se propage principalement selon x. Le premier dispositif optoélectronique présente ainsi une première dimension caractéristique W1 selon y.

Le premier dispositif optoélectronique comprend typiquement une ou plusieurs couches de passivation 100, 100' sur les flancs de la première structure 1 en saillie. Le premier dispositif optoélectronique comprend typiquement un premier contact électrique inférieur 101 configuré pour injecter des porteurs de charge, par exemple des électrons, dans la première couche active 11 via la première couche d'encapsulation inférieure 10, et un premier contact électrique supérieur 102 configuré pour injecter des porteurs de charge, par exemple des trous, dans la première couche active 11 via la première couche d'encapsulation supérieure 12. Le premier dispositif optoélectronique est par exemple un premier laser à cascade quantique à contre-réaction distribuée, émettant à la longueur d'onde $\lambda_1$.

Le deuxième dispositif optoélectronique comprend typiquement, en empilement selon z :

- Un deuxième substrat 210, de préférence à base de silicium.
- Une deuxième couche de collage 211, par exemple à base de SiO2.
- Une deuxième couche d'isolation optique 26, typiquement à base d'InP.
- Une deuxième couche d'arrêt de gravure 25 d'épaisseur $e_{25}$, par exemple à base d'InGaAs.
- Une deuxième couche d'encapsulation inférieure 20 d'épaisseur $e_{20}$, par exemple à base d'InP.
- Une deuxième couche inférieure de confinement optique 23 d'épaisseur $e_{23}$, par exemple à base d'InGaAs.
- Une deuxième couche active 21 d'épaisseur $e_{21}$, comprenant par exemple des puits quantiques multiples à base de ternaires AlInAs, GaInAs ou de quaternaires de type GaInAsP ou AlGaInAs. Cette deuxième couche active 21 est de préférence configurée pour émettre un deuxième rayonnement lumineux de longueur d'onde $\lambda_2$.
- Une deuxième couche supérieure de confinement optique 24 d'épaisseur $e_{24}$, par exemple à base d'InGaAs.
- Une deuxième couche d'encapsulation supérieure 22 d'épaisseur $e_{22}$, par exemple à base d'InP. Selon une possibilité, la deuxième couche d'encapsulation supérieure 22 peut être structurée sous forme de réseau 220. Un tel réseau 220 se présente typiquement, de façon connue, sous forme de tranchées régulièrement espacées selon x. Les tranchées du réseau 220 présentent une profondeur $d_2$ selon z et sont distribuées selon un pas de réseau $p_2$ selon x. La profondeur $d_2$ et le pas de réseau $p_2$ dépendent de la longueur d'onde $\lambda_2$.

L'empilement des couches 26, 25, 20, 23, 21, 24, 22 forme un deuxième empilement. Ce deuxième empilement est de préférence à base de matériaux III-V. Il peut être formé par épitaxie sur un substrat donneur, par exemple à base d'InP, puis éventuellement reporté sur le deuxième substrat 210, par exemple à base de silicium. Une deuxième couche de collage 211, par exemple à base d'oxyde de silicium, peut ainsi être intercalée entre le deuxième substrat 210 et le deuxième empilement. Lors de l'épitaxie, l'empilement se présente typiquement sous forme de couches planaires s'étendant sur toute la surface du substrat donneur. Cet empilement est ensuite structuré afin de réaliser le deuxième dispositif optoélectronique.

En particulier, l'empilement des couches 26, 25, 20, 23, 21, 24, 22 est au moins en partie gravé de manière à former une deuxième structure 2 en saillie de la couche d'isolation optique 26. Cette deuxième structure 2 en saillie permet notamment de confiner et/ou guider le deuxième rayonnement lumineux de longueur d'onde $\lambda_2$ émis par la deuxième couche active 21. Dans cet exemple, le deuxième rayonnement lumineux se propage principalement selon x. Le deuxième dispositif optoélectronique présente ainsi une deuxième dimension caractéristique W2 selon y.

Le deuxième dispositif optoélectronique comprend typiquement une ou plusieurs couches de passivation 200, 200' sur les flancs de la deuxième structure 2 en saillie. Le deuxième dispositif optoélectronique comprend typiquement un deuxième contact électrique inférieur 201 configuré pour injecter des porteurs de charge, par exemple des électrons, dans la deuxième couche active 21 via la deuxième couche d'encapsulation inférieure 20, et un deuxième contact électrique supérieur 202 configuré pour injecter des porteurs de charge, par exemple des trous, dans la deuxième couche active 21 via la deuxième couche d'encapsulation supérieure 22. Le deuxième dispositif optoélectronique est par exemple un deuxième laser à cascade quantique à contre-réaction distribuée, émettant à la longueur d'onde $\lambda_2$.

Un objet de la présente invention est de permettre la fabrication des premier et deuxième dispositifs optoélectroniques par une filière technologique en partie commune. Le principe retenu dans le cadre du développement de la présente invention porte sur un dimensionnement des couches des premier et deuxième empilements permettant d'obtenir une même hauteur h pour les première et deuxième structures 1, 2 en saillie des premier et deuxième dispositifs optoélectroniques. En particulier, la présente invention porte sur des règles de dimensionnement en épaisseur de la couche d'arrêt de gravure, de la couche d'encapsulation inférieure, de la couche inférieure de confinement optique, de la couche active, de la couche supérieure de confinement optique, de la couche d'encapsulation supérieure, pour chaque structure 1, 2 en saillie.

Selon un mode de réalisation, une première étape consiste à déterminer quelle est la hauteur h minimale permettant de faire fonctionner l'ensemble des dispositifs optoélectroniques. En pratique, la hauteur h minimale correspond typiquement au dispositif optoélectronique présentant la plus grande longueur d'onde de fonctionnement. Dans l'exemple illustré, la deuxième longueur d'onde $\lambda_2$ est supérieure à la première longueur d'onde $\lambda_1$. Les épaisseurs $e_{25}$, $e_{20}$, $e_{23}$, $e_{21}$, $e_{24}$, $e_{22}$ des couches 25, 20, 23, 21, 24, 22 sont donc d'abord fixées de façon à ce que le deuxième dispositif optoélectronique présente les propriétés optiques requises pour la deuxième longueur d'onde $\lambda_2$. Dans ce cas, $e_{25} + e_{20} + e_{23} + e_{21} + e_{24} + e_{22} = h$. Les épaisseurs $e_{15}$, $e_{10}$, $e_{13}$, $e_{11}$, $e_{14}$, $e_{12}$ des couches 15, 10, 13, 11, 14, 12 sont ensuite calculées à partir des épaisseurs $e_{25}$, $e_{20}$, $e_{23}$, $e_{21}$, $e_{24}$, $e_{22}$ des couches 25, 20, 23, 21, 24, 22. Ce calcul consiste typiquement à appliquer une homothétie pour les épaisseurs $e_{15}$, $e_{13}$, $e_{11}$, $e_{14}$, $e_{12}$ des couches 15, 13, 11, 14, 12, et à compenser la différence de hauteur vis-à-vis de h en faisant varier l'épaisseur $e_{10}$ de la couche 10. La première couche d'encapsulation inférieure 10 a un rôle de compensation en épaisseur et s'apparente donc à une couche tampon. Le facteur d'homothétie dépend des longueurs d'onde $\lambda_1$, $\lambda_2$.

Selon un exemple de dimensionnement, pour une deuxième longueur d'onde $\lambda_2 = 9{,}6\ \mu m$, les épaisseurs $e_{26}$, $e_{25}$, $e_{20}$, $e_{23}$, $e_{21}$, $e_{24}$, $e_{22}$ des couches 26, 25, 20, 23, 21, 24, 22 peuvent être fixées telles que :

- L'épaisseur e26 de la deuxième couche d'isolation optique 26 est de l'ordre de 6,5 $\mu m$,
- L'épaisseur e25 de la deuxième couche d'arrêt 25 est de l'ordre de 300 nm,
- L'épaisseur e20 de la deuxième couche d'encapsulation inférieure 20 est de l'ordre de 0,7 $\mu m$,
- L'épaisseur e23 de la deuxième couche inférieure de confinement optique 23 est de l'ordre de 175 nm,
- L'épaisseur e21 de la deuxième couche active 21 est de l'ordre de 3,09 $\mu m$,
- L'épaisseur e24 de la deuxième couche supérieure de confinement optique 24 est de l'ordre de 195 nm,
- L'épaisseur e22 de la deuxième couche d'encapsulation supérieure 22 est de l'ordre de 0,7 $\mu m$.

Selon une possibilité, les règles de dimensionnement s'écrivent, pour i = 1... n (avec n = 5 dans l'exemple illustré) :

$$e1i = e2i.\frac{\lambda 1}{\lambda 2}.\alpha i \ \text{avec}\ 0{,}7 \leq \alpha i \leq 1{,}3$$

$$e10 = e20 + \sum_{i=1}^{n} e2i - \sum_{i=1}^{n} e1i$$

$\alpha i$ est de préférence de l'ordre de 1. Cela permet d'optimiser les propriétés optiques de chaque empilement de couches, pour chaque dispositif optoélectronique. Une tolérance de $\pm$ 30% sur le facteur d'homothétie peut être appliquée pour chacune des épaisseurs $e1i$, sans que les performances des dispositifs optoélectroniques soient sensiblement dégradées.

Selon une autre possibilité, le facteur d'homothétie peut être corrigé de la dispersion d'indice de réfraction, selon :

$$e1i = e2i.\frac{\lambda 1}{\lambda 2}.\frac{n2}{n1}\ \text{avec}\ n1, n2\ \text{l'indice effectif des couches de l'empilement aux longueurs d'onde}\ \lambda_1, \lambda_2\ \text{respectivement.}$$

L'épaisseur $e_{16}$ de la première couche d'isolation optique 16 est de préférence sensiblement égale à l'épaisseur $e_{26}$ de la deuxième couche d'isolation optique 26. Les premier et deuxième empilements de couches à base de matériaux III-V présentent ainsi une hauteur totale sensiblement identique.

La même homothétie peut être appliquée aux autres dimensions de la première structure 1 en saillie, en particulier à la largeur W1 selon y et à la longueur L1 selon x (non illustrée sur la coupe yz des figures d'accompagnement).

Selon une possibilité, les règles de dimensionnement pour la largeur W1 et la longueur L1 s'écrivent :

$$W1 = W2.\frac{\lambda_1}{\lambda_2}.\alpha_W \text{ avec } 0,7 \le \alpha_W \le 1,3$$

$$L1 = L2.\frac{\lambda_1}{\lambda_2}.\alpha_L \text{ avec } 0,7 \le \alpha_L \le 1,3.$$

Une tolérance de $\pm$ 30% sur le facteur d'homothétie peut être appliquée pour chacune de ces dimensions W1, L1. Les performances des dispositifs optoélectroniques restent sensiblement constantes dans cette gamme de dimensions.

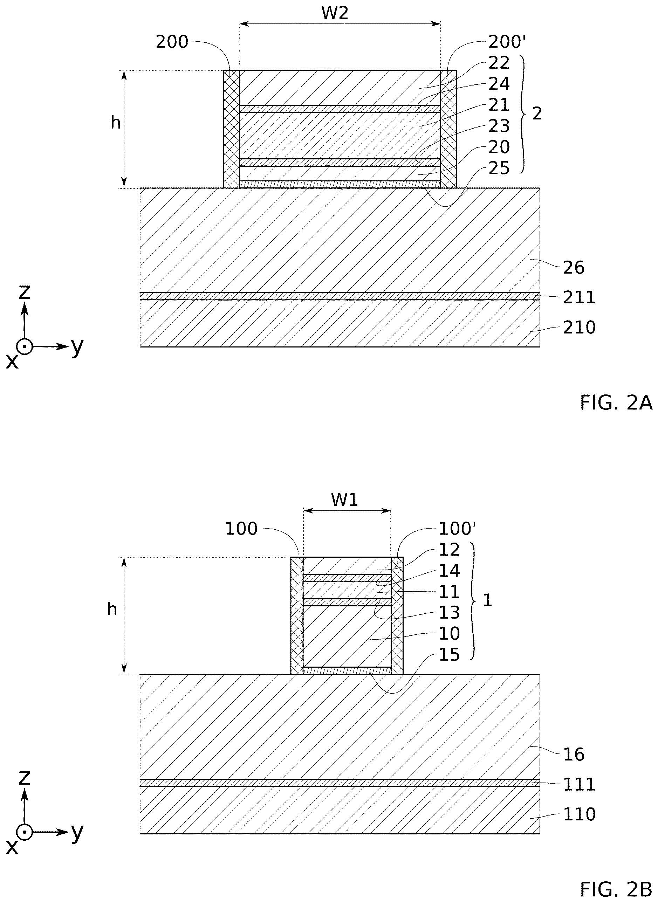

Les figures 2A, 2B illustrent respectivement un deuxième dispositif optoélectronique et un premier dispositif optoélectronique comprenant des deuxième et première structures en saillie de même hauteur h. Le deuxième dispositif optoélectronique est dimensionné pour fonctionner à une longueur d'onde $\lambda_2$ = 9,6 $\mu$m. Le premier dispositif optoélectronique est dimensionné pour fonctionner à une longueur d'onde $\lambda_1$ = 4,2 $\mu$m. Les épaisseurs des couches 15, 10, 13, 11, 14, 12 de la première structure 1 en saillie ont été dimensionnées selon les règles de dimensionnement énoncées ci-dessus ([Math19] et [Math 20]), à partir des épaisseurs des couches 25, 20, 23, 21, 24, 22 de la deuxième structure 2 en saillie.

La largeur W1 de la première structure 1 en saillie a également été dimensionnée selon les règles de dimensionnement énoncées ci-dessus ([Math 22] et [Math 23]), à partir de la largeur W2 de la deuxième structure 2 en saillie.

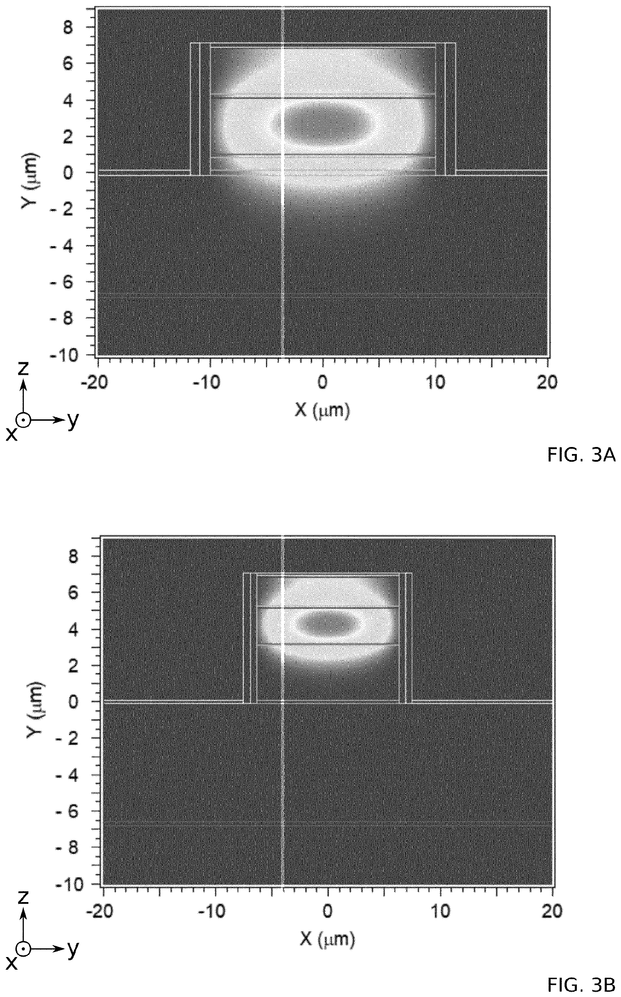

Les figures 3A, 3B illustrent respectivement les distributions des deuxième et premier rayonnements lumineux dans les deuxième et premier dispositifs optoélectroniques illustrés aux figures 2A, 2B. Il apparaît que le dimensionnement effectué selon les règles de dimensionnement énoncées ci-dessus permet de confiner efficacement chacun des deuxième et premier rayonnements lumineux au sein des deuxième et premier dispositifs optoélectroniques. Ainsi, les premier et deuxième dispositifs optoélectroniques présentent les propriétés optiques requises pour leur fonctionnement, tout en présentant avantageusement des première et deuxième structures en saillie de même hauteur h.

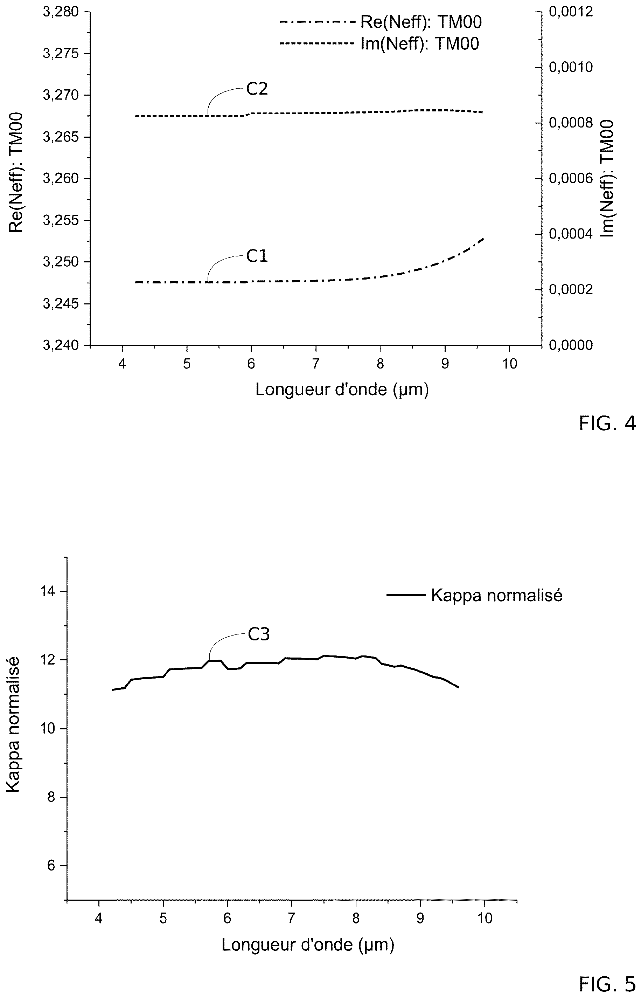

Les figures 4 et 5 illustrent les variations de certains paramètres optiques en fonction de la longueur d'onde, pour une infinité de dispositifs optoélectroniques dimensionnés « par homothétie », selon les règles de dimensionnement énoncées ci-dessus. Il apparaît que le dimensionnement par homothétie permet d'obtenir des indices effectifs (figure 4, courbe C1) quasiment constants en fonction de la longueur d'onde, entre 4,2 $\mu$m et 9,6 $\mu$m. Le dimensionnement par homothétie permet également de maintenir les pertes optiques (figure 4, courbe C2) à un niveau très faible pour des longueurs d'onde entre 4,2 $\mu$m et 9,6 $\mu$m. Le dimensionnement par homothétie permet également d'obtenir une constante de couplage normalisée $\kappa$* (figure 5, courbe C3) quasiment constante entre 4,2 $\mu$m et 9,6 $\mu$m.

En pratique, le dimensionnement par homothétie est effectué pour quelques longueurs d'onde seulement de la gamme de longueurs d'onde du MIR. Par exemple, la gamme de longueurs d'onde est subdivisée en intervalles d'environ 500 nm ou 1 $\mu$m, et le dimensionnement par homothétie est effectué pour les longueurs d'onde centrales de ces intervalles.

Le dimensionnement par homothétie permet notamment de fabriquer des lasers à cascade quantique (QCL) à contre-réaction distribuée (DFB) émettant dans une large gamme de longueurs d'onde du MIR avec des propriétés satisfaisantes, tout en fournissant avantageusement une hauteur h de dispositif constante. Cela permet de mutualiser un certain nombre d'étapes technologiques après formation des différents empilements correspondants aux différents dispositifs.

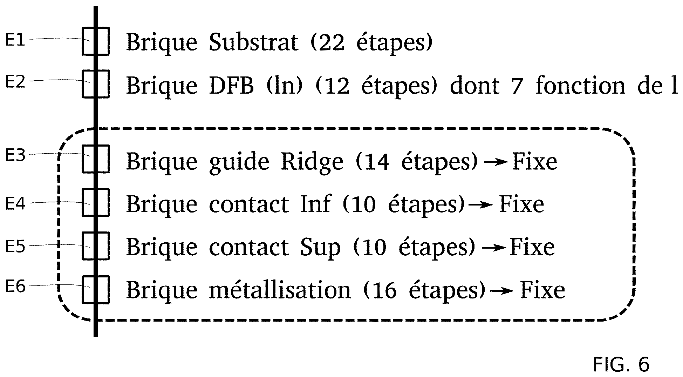

La figure 6 illustre un flux de procédé technologique correspondant à la fabrication de lasers QCL DFB.

La brique E1 correspond à la formation de l'empilement des couches sur le substrat. La brique E1 comprend typiquement vingt-deux étapes. Cette brique E1 est spécifique au dispositif à fabriquer. Les vingt-deux étapes sont donc répétées n fois pour fabriquer n dispositifs différents.

La brique E2 correspond à la gravure du DFB sur l'empilement des couches. La brique E2 comprend typiquement douze étapes. Le dimensionnement du DFB dépend de la longueur d'onde. Cette brique E2 est donc spécifique au dispositif à fabriquer. Les douze étapes, donc certaines peuvent être mutualisées, sont donc répétées n fois pour fabriquer n dispositifs différents.

La brique E3 correspond à la gravure de l'empilement pour former la structure en saillie des dispositifs. La brique E3 comprend typiquement quatorze étapes. Avantageusement, les n dispositifs différents présentent selon l'invention une structure en saillie de même hauteur h. La brique E3 peut donc être effectuée une seule fois pour l'ensemble des n dispositifs. Cette brique E3 comprend un ensemble d'étapes commun à la fabrication des n dispositifs différents.

La brique E4 correspond à la formation du contact inférieur des dispositifs. La brique E4 comprend typiquement dix étapes. Avantageusement, les n dispositifs différents présentent selon l'invention une structure en saillie de même hauteur h. La brique E4 peut donc être effectuée une seule fois pour l'ensemble des n dispositifs. Cette brique E4 comprend un ensemble d'étapes (par exemple étalement de résine de photolithographie, insolation de la résine selon une même focale, dépôt, retrait CMP selon une même hauteur etc) commun à la fabrication des n dispositifs différents.

La brique E5 correspond à la formation du contact supérieur des dispositifs. La brique E5 comprend typiquement dix étapes. Avantageusement, les n dispositifs différents présentent selon l'invention une structure en saillie de même hauteur h. La brique E5 peut donc être effectuée une seule fois pour l'ensemble des n dispositifs. Cette brique E5 comprend un ensemble d'étapes (par exemple étalement de résine de photolithographie, insolation de la résine selon une même focale, dépôt, retrait CMP selon une même hauteur etc) commun à la fabrication des n dispositifs différents.

La brique E6 correspond à une métallisation ; cela peut permettre, à titre indicatif, de former des plots métalliques sur les contacts électriques sur les DFB et de former des éléments de routage pour la sortie des contacts inférieurs et supérieurs. La brique E6 comprend typiquement seize étapes. Avantageusement, les n dispositifs différents présentent selon l'invention une structure en saillie de même hauteur h. La brique E6 peut donc être effectuée une seule fois pour l'ensemble des n dispositifs. Cette brique E6 comprend un ensemble d'étapes commun à la fabrication des n dispositifs différents.

Contrairement aux flux de procédés classiques dans lesquels les briques E1 à E6 sont toutes effectuées n fois pour fabriquer n dispositifs différents (soit un total de n*84 étapes), le flux selon l'invention permet, selon un exemple, de mutualiser les briques E3 à E6 (50 étapes). Seules les briques E1 et E2 (34 étapes) restent spécifiques aux n dispositifs à fabriquer. Le flux de procédé selon l'invention permet ainsi de diminuer avantageusement le nombre total d'étapes à n*34 + 50.

De ce qui précède, il apparaît clairement que la présente invention permet avantageusement de diminuer significativement le nombre total d'étapes de fabrication de n dispositifs optoélectroniques fonctionnant à n longueurs d'onde différentes. Le temps de fabrication et le coût de fabrication de ces n dispositifs sont ainsi avantageusement diminués.

Une application particulière du procédé de fabrication selon l'invention concerne la réalisation de lasers à cascade quantique (QCL) à contre-réaction distribuée (DFB) émettant dans une large gamme de longueurs d'onde du MIR. D'autres applications peuvent être envisagées. L'invention n'est pas limitée aux modes de réalisation précédemment décrits.

## Revendications

1. Procédé de fabrication d'au moins un premier dispositif optoélectronique fonctionnant à une première longueur d'onde $\lambda 1$ et un deuxième dispositif optoélectronique fonctionnant à une deuxième longueur d'onde $\lambda 2 > \lambda 1$, le premier dispositif optoélectronique comprenant un premier empilement selon une direction z sur un premier substrat (110), le premier empilement comprenant une première couche (10) d'encapsulation inférieure d'épaisseur e10 selon la direction z et une pluralité de premières couches (11, 12, 13, 14, 15) d'épaisseur e1i (i = 1...n) selon la direction z, et le deuxième dispositif optoélectronique comprenant un deuxième empilement selon la direction z sur un deuxième substrat (210), le deuxième empilement comprenant une deuxième couche (20) d'encapsulation inférieure d'épaisseur e20 selon la direction z et une pluralité de deuxièmes couches (21, 22, 23, 24, 25) d'épaisseur e2i (i = 1...m) selon la direction z, lesdites deuxièmes couches (21, 22, 23, 24, 25) d'épaisseur e2i présentant des fonctions optiques semblables à celles des premières couches (11, 12, 13, 14, 15) d'épaisseur e1i, le procédé comprenant les étapes suivantes :

   • Former le deuxième empilement sur le deuxième substrat (210) en dimensionnant les épaisseurs e20 et e2i en fonction de la deuxième longueur d'onde $\lambda 2$,
   • Former le premier empilement sur le premier substrat (110) en dimensionnant les épaisseurs e10 et e1i selon :

$$e1i = e2i.\frac{\lambda 1}{\lambda 2}.\alpha i \text{ avec } 0,7 \leq \alpha i \leq 1,3$$

$$e10 = e20 + \sum_{i=1}^{n} e2i - \sum_{i=1}^{n} e1i$$

   • Réaliser au moins une même étape technologique (E3, E4, E5, E6) sur les premier et deuxième empilements, par exemple une gravure des premier et deuxième empilements selon une même profondeur selon z, de façon à obtenir les premier et deuxième dispositifs optoélectroniques.

2. Procédé selon la revendication précédente dans lequel l'au moins une même étape technologique (E3, E4, E5, E6) comprend une ou plusieurs étapes prises parmi : une gravure selon z d'un motif de guide d'onde, une passivation, une formation d'un contact électrique supérieur (102, 202), une formation d'un contact électrique inférieur (101, 201), une métallisation.

3. Procédé selon l'une quelconque des revendications précédentes dans lequel la pluralité de premières couches d'épaisseur e1i comprend au moins une première couche active (11) d'épaisseur e11 selon z, destinée à émettre ou recevoir un rayonnement présentant la première longueur d'onde λ1, et une première couche (12) d'encapsulation supérieure d'épaisseur e12 selon z, et dans lequel la pluralité de deuxièmes couches d'épaisseur e2i comprend au moins une deuxième couche active (21) d'épaisseur e21 selon z, destinée à émettre ou recevoir un rayonnement présentant la deuxième longueur d'onde λ2, et une deuxième couche (22) d'encapsulation supérieure d'épaisseur e22 selon z.

4. Procédé selon la revendication précédente, dans lequel la pluralité de premières couches d'épaisseur e1i comprend en outre une première couche (13) inférieure de confinement optique d'épaisseur e13 intercalée entre la première couche (10) d'encapsulation inférieure et la première couche active (11), et une première couche (14) supérieure de confinement optique d'épaisseur e14 intercalée entre la première couche (12) d'encapsulation supérieure et la première couche active (11), et dans lequel la pluralité de deuxièmes couches d'épaisseur e2i comprend en outre une deuxième couche (23) inférieure de confinement optique d'épaisseur e23 intercalée entre la deuxième couche (20) d'encapsulation inférieure et la deuxième couche active (21), et une deuxième couche (24) supérieure de confinement optique d'épaisseur e24 intercalée entre la deuxième couche (22) d'encapsulation supérieure et la deuxième couche active (21), avec :

- 
$$e11 = e21.\frac{\lambda 1}{\lambda 2}.\alpha 1 \text{ avec } 0{,}7 \leq \alpha 1 \leq 1{,}3$$

- 
$$e12 = e22.\frac{\lambda 1}{\lambda 2}.\alpha 2 \text{ avec } 0{,}7 \leq \alpha 2 \leq 1{,}3$$

- 
$$e13 = e23.\frac{\lambda 1}{\lambda 2}.\alpha 3 \text{ avec } 0{,}7 \leq \alpha 3 \leq 1{,}3$$

- 
$$e14 = e24.\frac{\lambda 1}{\lambda 2}.\alpha 4 \text{ avec } 0{,}7 \leq \alpha 4 \leq 1{,}3$$

- 
$$e10 = (e20 + e21 + e22 + e23 + e24) - (e12 + e11 + e13 + e14).$$

5. Procédé selon la revendication précédente, dans lequel la pluralité de premières couches d'épaisseur e1i comprend en outre une première couche d'arrêt (15) d'épaisseur e15 sous la première couche (10) d'encapsulation inférieure, et dans lequel la pluralité de deuxièmes couches d'épaisseur e2i comprend en outre une deuxième couche d'arrêt (25) d'épaisseur e25 sous la deuxième couche (20) d'encapsulation inférieure, avec :

- 
$$e15 = e25.\frac{\lambda 1}{\lambda 2}.\alpha 5 \text{ avec } 0{,}7 \leq \alpha 5 \leq 1{,}3.$$

6. Procédé selon l'une quelconque des revendications précédentes dans lequel les premier et deuxième empilements sont gravés selon une même profondeur h selon z pour former des première et deuxième structures (1, 2) en saillie, présentant respectivement une première largeur W1 selon une direction x et une première longueur L1 selon une direction y, et une deuxième largeur W2 selon la direction x et une deuxième longueur L2 selon la direction y, ledit procédé comprenant en outre, avant gravure des premier et deuxième empilements (1, 2) :

• Déterminer la deuxième largeur W2 et la deuxième longueur L2 en fonction de la deuxième longueur d'onde λ2,
• Déterminer la première largeur W1 et la première longueur L1 selon :

- 

$$W1 = W2.\frac{\lambda 1}{\lambda 2}.\alpha_W \text{ avec } 0{,}7 \leq \alpha_W \leq 1{,}3$$

- 

$$L1 = L2.\frac{\lambda 1}{\lambda 2}.\alpha_L \text{ avec } 0{,}7 \leq \alpha_L \leq 1{,}3.$$

7. Procédé selon l'une quelconque des revendications précédentes comprenant en outre une première gravure configurée pour former un premier réseau (120) présentant une première profondeur d1 sur le premier empilement porté par le premier substrat (110), et indépendamment une deuxième gravure configurée pour former un deuxième réseau (220) présentant une deuxième profondeur d2 sur le deuxième empilement porté par le deuxième substrat (220).

8. Procédé selon l'une quelconque des revendications précédentes dans lequel les première et deuxième longueurs d'onde λ1, λ2 sont choisies dans le domaine du moyen infrarouge entre 2 μm et 15 μm, de préférence entre 4 μm et 10 μm.

9. Système pour la fabrication d'au moins un premier dispositif optoélectronique fonctionnant à une première longueur d'onde λ1 et un deuxième dispositif optoélectronique fonctionnant à une deuxième longueur d'onde λ2 > λ1, le système comprenant au moins un premier substrat (110) portant un premier empilement selon une direction z comprenant une première couche (10) d'encapsulation inférieure d'épaisseur e10 selon la direction z et une pluralité de premières couches (11, 12, 13, 14, 15) d'épaisseur e1i (i = 1...n) selon la direction z, et un deuxième substrat (210) portant un deuxième empilement selon la direction z comprenant une deuxième couche (20) d'encapsulation inférieure d'épaisseur e20 selon la direction z et une pluralité de deuxièmes couches (21, 22, 23, 24, 25) d'épaisseur e2i (i = 1...m) selon la direction z, lesdites deuxièmes couches d'épaisseur e2i présentant des fonctions optiques semblables à celles des premières couches d'épaisseur e1i, les épaisseurs e10, e20 et e1i, e2i vérifiant les relations suivantes :

- 

$$e1i = e2i.\frac{\lambda 1}{\lambda 2}.\alpha i \text{ avec } 0{,}7 \leq \alpha i \leq 1{,}3$$

- 

$$e10 = e20 + \sum_{i=1}^{n} e2i - \sum_{i=1}^{n} e1i$$

de sorte que les premier et deuxième empilements présentent sensiblement une même hauteur selon z.

10. Système selon la revendication précédente dans lequel le premier empilement est bordé par des premières tranchées de profondeur h selon la direction z et forme une première structure en saillie (1), et le deuxième empilement est bordé par des deuxièmes tranchées de même profondeur h selon la direction z et forme une deuxième structure en saillie (2).

11. Système selon la revendication précédente dans lequel la première structure en saillie (1) présente une première largeur W1 selon une direction x et une première longueur L1 selon une direction y, et la deuxième structure en saillie (2) présente une deuxième largeur W2 selon la direction x et une deuxième longueur L2 selon la direction y, les première et deuxième largeurs W1, W2 et les première et deuxième longueurs L1, L2 vérifiant les relations suivantes :

- 

$$W1 = W2.\frac{\lambda 1}{\lambda 2}.\alpha_W \text{ avec } 0,7 \leq \alpha_W \leq 1,3$$

- 

$$L1 = L2.\frac{\lambda 1}{\lambda 2}.\alpha_L \text{ avec } 0,7 \leq \alpha_L \leq 1,3.$$

**12.** Système selon l'une quelconque des revendications 9 à 11 dans lequel la pluralité de premières couches (11, 12, 13, 14, 15) d'épaisseur e1i comprend au moins une première couche active (11) d'épaisseur e11 selon z, destinée à émettre ou recevoir un rayonnement présentant la première longueur d'onde λ1, et une première couche (12) d'encapsulation supérieure d'épaisseur e12 selon z, et dans lequel la pluralité de deuxièmes couches (21, 22, 23, 24, 25) d'épaisseur e2i comprend au moins une deuxième couche active (21) d'épaisseur e21 selon z, destinée à émettre ou recevoir un rayonnement présentant la deuxième longueur d'onde λ2, et une deuxième couche (22) d'encapsulation supérieure d'épaisseur e22 selon z, avec :

- 

$$e12 = e22.\frac{\lambda 1}{\lambda 2}.\alpha 2 \text{ avec } 0,7 \leq \alpha 2 \leq 1,3$$

- 

$$e11 = e21.\frac{\lambda 1}{\lambda 2}.\alpha 1 \text{ avec } 0,7 \leq \alpha 1 \leq 1,3.$$

**13.** Système selon l'une quelconque des revendications 9 à 12 dans lequel les premier et deuxième substrats (110, 210) sont à base de silicium et dans lequel les premier et deuxième empilements sont à base de matériaux III-V, les premier et deuxième empilements comprenant respectivement des première et deuxième couches d'isolation optique (16, 26) configurées pour éviter un couplage optique aux longueurs d'onde λ1 et λ2 avec les premier et deuxième substrats (110, 210).

**14.** Système selon l'une quelconque des revendications 9 à 13 dans lequel les premier et deuxième dispositifs optoélectroniques correspondent à des premier et deuxième lasers à cascade quantique à contre-réaction distribuée.

**Patentansprüche**

**1.** Verfahren zur Herstellung mindestens einer ersten optoelektronischen Vorrichtung, die bei einer ersten Wellenlänge Δ1 arbeitet, und einer zweiten optoelektronischen Vorrichtung, die bei einer zweiten Wellenlänge Δ2 > Δ1 arbeitet, wobei die erste optoelektronische Vorrichtung eine erste Stapelung gemäß einer Richtung z auf einem ersten Substrat (110) umfasst, die erste Stapelung eine erste untere Kapselungsschicht (10) umfasst, mit einer Dicke e10 gemäß der Richtung z, und eine Vielzahl erster Schichten (11, 12, 13, 14, 15) mit einer Dicke e1i (i = 1...n) gemäß der Richtung z, und wobei die zweite optoelektronische Vorrichtung eine zweite Stapelung gemäß der Richtung z auf einem zweiten Substrat (210) umfasst, wobei die zweite Stapelung eine zweite untere Kapselungsschicht (20) mit einer Dicke e20 gemäß der Richtung z und eine Vielzahl zweiter Schichten (21, 22, 23, 24, 25) mit einer Dicke e2i (i = 1...m) gemäß der Richtung z umfasst, wobei die zweiten Schichten (21, 22, 23, 24, 25) mit einer Dicke e2i optische Funktionen ähnlich denjenigen der ersten Schichten (11, 12, 13, 14, 15) mit einer Dicke e1i umfasst, wobei das Verfahren die folgenden Schritte umfasst:

• Bilden einer zweiten Stapelung auf dem zweiten Substrat (210) unter Bemessen der Dicken e20 und e2i in Abhängigkeit von der zweiten Wellenlänge Δ2,
• Bilden der ersten Stapelung auf dem ersten Substrat (110) unter Bemessen der Dicken e10 und e1i gemäß:

$$e1i = e2i.\frac{\lambda 1}{\lambda 2}.\alpha i \quad \texttt{mit} \quad 0,7 \leq \alpha i \leq 1,3$$

$$e10 = e20 + \sum_{i=1}^{n} e2i - \sum_{i=1}^{n} e1i$$

• Durchführen eines zweiten technologischen Schritts (E3, E4, E5, E6) auf der ersten und der zweiten Stapelung, beispielsweise einer Ätzung der ersten und der zweiten Stapelung gemäß derselben Tiefe gemäß z derart, dass die erste und die zweite optoelektronische Vorrichtung erhalten werden.

2. Verfahren nach dem vorstehenden Anspruch, wobei der mindestens eine gleiche technologischer Schritt (E3, E4, E5, E6) einen oder mehrere der Schritte umfasst von: einer Ätzung gemäß z einer Wellenleiterstruktur, einer Passivierung, einer Bildung eines oberen elektrischen Kontakts (102, 202), einer Bildung eines unteren elektrischen Kontakts (101, 201, einer Metallisierung.

3. Verfahren nach einem der vorstehenden Ansprüche, wobei die Vielzahl erster Schichten mit einer Dicke e1i mindestens eine erste aktive Schicht (11) mit Dicke einer e11 gemäß z umfasst, die dazu bestimmt ist, eine Strahlung zu emittieren oder zu empfangen, die die erste Wellenlänge $\Delta$1 aufweist, und eine erste obere Kapselungsschicht (12) mit einer Dicke e12 gemäß z, und wobei die Vielzahl zweiter Schichten mit der Dicke e2i mindestens eine zweite aktive Schicht (21) mit einer Dicke e21 gemäß z umfasst, die dazu bestimmt ist, eine Strahlung zu emittieren oder zu empfangen, die die zweite Wellenlänge $\Delta$2 aufweist, und eine zweite obere Kapselungsschicht (22) mit einer Dicke e22 gemäß z.

4. Verfahren nach dem vorstehenden Anspruch, wobei die Vielzahl erster Schichten mit der Dicke e1i außerdem eine erste untere optische Begrenzungsschicht (13) mit einer Dicke e13 umfasst, die zwischen der ersten unteren Kapselungsschicht (10) und der ersten aktiven Schicht (11) eingefügt ist, und eine erste obere optische Begrenzungsschicht (14) mit einer Dicke e14, die zwischen der ersten oberen Kapselungsschicht (12) und der ersten aktiven Schicht (11) eingefügt ist, und wobei die Vielzahl zweiter Schichten mit der Dicke e2i außerdem eine zweite untere optische Begrenzungsschicht (23) mit einer Dicke e23 umfasst, die zwischen der zweiten unteren Kapselungsschicht (20) und der zweiten aktiven Schicht (21) eingefügt ist, und eine zweite obere optische Begrenzungsschicht (24) mit einer Dicke e24, die zwischen der zweiten oberen Kapselungsschicht (22) und der zweiten aktiven Schicht (21) eingefügt ist, wobei:

•

$$e11 = e21.\frac{\lambda 1}{\lambda 2}.\alpha 1 \text{ avec } 0,7 \leq \alpha 1 \leq 1,3$$

•

$$e12 = e22.\frac{\lambda 1}{\lambda 2}.\alpha 2 \text{ avec } 0,7 \leq \alpha 2 \leq 1,3$$

•

$$e13 = e23.\frac{\lambda 1}{\lambda 2}.\alpha 3 \text{ avec } 0,7 \leq \alpha 3 \leq 1,3$$

•

$$e14 = e24.\frac{\lambda 1}{\lambda 2}.\alpha 4 \text{ avec } 0,7 \leq \alpha 4 \leq 1,3$$

•

$$e10 = (e20 + e21 + e22 + e23 + e24) - (e12 + e11 + e13 + e14).$$

5. Verfahren nach dem vorstehenden Anspruch, wobei die Vielzahl erster Schichten mit der Dicke e1i außerdem eine erste Stoppschicht (15) mit einer Dicke e15 unter der ersten unteren Kapselungsschicht (10) umfasst, und wobei die Vielzahl zweiter Schichten mit der Dicke e2i außerdem eine zweite Stoppschicht (25) mit einer Dicke e25 unter der zweiten unteren Kapselungsschicht (20) umfasst, wobei:

- 
$$e15 = e25.\frac{\lambda 1}{\lambda 2}.\alpha 5 \text{ avec } 0,7 \leq \alpha 5 \leq 1,3.$$

6. Verfahren nach einem der vorstehenden Ansprüche, wobei die erste und die zweite Stapelung gemäß derselben Tiefe h gemäß z geätzt werden, um eine erste und eine zweite vorragende Struktur (1, 2) zu bilden, die jeweils eine erste Breite W1 gemäß einer Richtung x und eine erste Länge L1 gemäß einer Richtung y und eine zweite Breite W2 gemäß der Richtung x und eine zweite Länge L2 gemäß der Richtung y aufweisen, wobei das Verfahren außerdem vor dem Ätzen der ersten und der zweiten Stapelung (1, 2) Folgendes umfasst:

- Bestimmen der zweiten Breite W2 und der zweiten Länge L2 in Abhängigkeit von der zweiten Wellenlänge ∆2,
- Bestimmen der ersten Breite W1 und der zweiten Länge L1 gemäß:

  - 
$$W1 = W2.\frac{\lambda 1}{\lambda 2}.\alpha_W \text{ avec } 0,7 \leq \alpha_W \leq 1,3$$

  - 
$$L1 = L2.\frac{\lambda 1}{\lambda 2}.\alpha_L \text{ avec } 0,7 \leq \alpha_L \leq 1,3.$$

7. Verfahren nach einem der vorstehenden Ansprüche, das außerdem eine erste Ätzung umfasst, die dazu konfiguriert ist, ein erstes Netzwerk (120) zu bilden, das eine erste Tiefe d1 auf der ersten Stapelung aufweist, die von dem ersten Substrat (110) getragen wird, und unabhängig eine zweite Ätzung, die dazu konfiguriert ist, ein zweites Netzwerk (220) zu bilden, das eine zweite Tiefe d2 auf der zweiten Stapelung umfasst, die von dem zweiten Substrat (220) getragen wird.

8. Verfahren nach einem der vorstehenden Ansprüche, wobei die erste und die zweite Wellenlänge ∆1, ∆2 aus dem mittleren Infrarotbereich zwischen 2 µm und 15 µm, bevorzugt zwischen 4 µm und 10 µm ausgewählt werden.

9. System zur Herstellung mindestens einer ersten optoelektronischen Vorrichtung, die bei einer ersten Wellenlänge ∆1 arbeitet, und einer zweiten optoelektronischen Vorrichtung, die bei einer zweiten Wellenlänge ∆2 > ∆1 arbeitet, wobei das System mindestens ein erstes Substrat (110) umfasst, das eine erste Stapelung gemäß einer Richtung z trägt, die eine erste untere Kapselungsschicht (10) mit einer Dicke e10 gemäß der Richtung z und eine Vielzahl erster Schichten (11, 12, 13, 14, 15) mit einer der Dicke e1i (i = 1 ... n) gemäß der Richtung z umfasst, und ein zweites Substrat (210), das eine zweite Stapelung gemäß der Richtung z trägt, die eine zweite untere Kapselungsschicht (20) mit der Dicke e20 gemäß der Richtung z und eine Vielzahl zweiter Schichten (21, 22, 23, 24, 25) mit der Dicke e2i (i = 1...m) gemäß der Richtung z umfasst, wobei die zweiten Schichten mit der Dicke e2i optische Funktionen ähnlich denjenigen der ersten Schichten mit der Dicke e1i aufweisen, wobei die Dicken e10, e20 und eli, e2i die folgenden Beziehungen erfüllen:

- 
$$e1i = e2i.\frac{\lambda 1}{\lambda 2}.\alpha i \text{ avec } 0,7 \leq \alpha i \leq 1,3$$

$$e10 = e20 + \sum_{i=1}^{n} e2i - \sum_{i=1}^{n} e1i$$

so dass die erste und die zweite Stapelung im Wesentlichen dieselbe Höhe gemäß z aufweisen.

10. System nach dem vorstehenden Anspruch, wobei die erste Stapelung von ersten Gräben mit der Tiefe h gemäß der Richtung z begrenzt sind und eine erste vorragende Struktur (1) bildet, und die zweite Stapelung von zweiten Gräben mit derselben Tiefe h gemäß der Richtung z begrenzt ist und eine zweite vorragende Struktur (2) bildet.

11. System nach dem vorstehenden Anspruch, wobei die erste vorragende Struktur (1) eine erste Breite W1 gemäß einer Richtung x und eine erste Länge L1 gemäß einer Richtung y aufweist, und die zweite vorragende Struktur (2) eine zweite Breite W2 gemäß der Richtung x und eine zweite Länge L2 gemäß der Richtung y aufweist, wobei die erste und die zweite Breite W1, W2 und die erste und zweite Länge L1, L2 die folgenden Beziehungen erfüllen:

$$W1 = W2.\frac{\lambda 1}{\lambda 2}.\alpha_W \text{ avec } 0{,}7 \leq \alpha_W \leq 1{,}3$$

$$L1 = L2.\frac{\lambda 1}{\lambda 2}.\alpha_L \text{ avec } 0{,}7 \leq \alpha_L \leq 1{,}3.$$

12. System nach einem der vorstehenden Ansprüche 9 bis 11, wobei die Vielzahl erster Schichten (11, 12, 13, 14, 15) mit der Dicke e1i mindestens eine erste aktive Schicht (11) mit der Dicke e11 gemäß z umfasst, die dazu bestimmt ist, eine Strahlung zu emittieren oder zu empfangen, die die erste Wellenlänge $\Delta 1$ aufweist, und eine erste obere Kapselungsschicht (12) mit der Dicke e12 gemäß z, und wobei die Vielzahl zweiter Schichten (21, 22, 23, 24, 25) mit der Dicke e2i mindestens eine zweite aktive Schicht (21) mit der Dicke e21 gemäß z umfasst, die dazu bestimmt ist, eine Strahlung zu emittieren oder zu empfangen, die die zweite Wellenlänge $\Delta 2$ aufweist, und eine zweite obere Kapselungsschicht (22) mit der Dicke e22 gemäß z, wobei:

$$e12 = e22.\frac{\lambda 1}{\lambda 2}.\alpha 2 \text{ avec } 0{,}7 \leq \alpha 2 \leq 1{,}3$$

$$e11 = e21.\frac{\lambda 1}{\lambda 2}.\alpha 1 \text{ avec } 0{,}7 \leq \alpha 1 \leq 1{,}3.$$

13. System nach einem der Ansprüche 9 bis 12, wobei das erste und das zweite Substrat (110, 210) auf Silizium basieren und die erste und die zweite Stapelung auf III-V Materialien basieren, wobei die erste und die zweite Stapelung jeweils eine erste und eine zweite optische Isolationsschicht (16, 26) umfassen, die dazu konfiguriert sind, ein optisches Koppeln bei den Wellenlängen $\Delta 1$ und $\Delta 2$ mit dem ersten und dem zweiten Substrat (110, 210) zu vermeiden.

14. System nach einem der Ansprüche 9 bis 13, wobei die erste und die zweite optoelektronische Vorrichtung einem ersten und einem zweiten Quantenkaskadenlaser mit verteilter Rückkopplung entsprechen.

**Claims**

1. A method for manufacturing at least one first optoelectronic device operating at a first wavelength $\lambda 1$ and a second

optoelectronic device operating at a second wavelength $\lambda 2 > \lambda 1$, the first optoelectronic device comprising a first stack along a direction z on a first substrate (110), the first stack comprising a first lower encapsulation layer (10) of thickness e10 along the direction z and a plurality of first layers (11, 12, 13, 14, 15) of thickness e1i (i = 1...n) along the direction z, and the second optoelectronic device comprising a second stack along the direction z on a second substrate (210), the second stack comprising a second lower encapsulation layer (20) of thickness e20 along the direction z and a plurality of second layers (21, 22, 23, 24, 25) of thickness e2i (i = 1...m) along the direction z, said second layers (21, 22, 23, 24, 25) of thickness e2i having optical functions similar to those of the first layers (11, 12, 13, 14, 15) of thickness e1i, the method comprising the following steps:

- Forming the second stack on the second substrate (210) by sizing the thicknesses e20 and e2i according to the second wavelength $\lambda 2$,
- Forming the first stack on the first substrate (110) by sizing the thicknesses e10 and e1i according to:

$$e1i = e2i.\frac{\lambda 1}{\lambda 2}.\alpha i \text{ with } 0.7 \leq \alpha i \leq 1.3$$

$$e10 = e20 + \sum_{i=1}^{n} e2i - \sum_{i=1}^{n} e1i$$

- Carrying out at least one same technological step (E3, E4, E5, E6) on the first and second stacks, for example, an etching of the first and second stacks along one same depth along z, so as to obtain the first and second optoelectronic devices.

2. The method according to the preceding claim, wherein the at least one same technological step (E3, E4, E5, E6) comprises one or more steps taken from among: an etching along z of a waveguide pattern, a passivation, a formation of an upper electric contact (102, 202), a formation of a lower electric contact (101, 201), a metallisation.

3. The method according to any one of the preceding claims, wherein the plurality of first layers of thickness e1i comprises at least one first active layer (11) of thickness e11 along z, intended to emit or receive a radiation having the first wavelength $\lambda 1$, and a first upper encapsulation layer (12) of thickness e12 along z, and in which the plurality of second layers of thickness e2i comprises at least one second active layer (21) of thickness e21 along z, intended to emit or receive a radiation having the second wavelength $\lambda 2$, and a second upper encapsulation layer (22) of thickness e22 along z.

4. The method according to the preceding claim, wherein the plurality of first layers of thickness e1i further comprises a first lower optical confinement layer (13) of thickness e13 inserted between the first lower encapsulation layer (10) and the first active layer (11), and a first upper optical confinement layer (14) of thickness e14 inserted between the first upper encapsulation layer (12) and the first active layer (11), and wherein the plurality of second layers of thickness e2i further comprises a second lower optical confinement layer (23) of thickness e23 inserted between the second lower encapsulation layer (20) and the second active layer (21), and a second upper optical confinement layer (24) of thickness e24 inserted between the second upper encapsulation layer (22) and the second active layer (21) with:

- 

$$e11 = e21.\frac{\lambda 1}{\lambda 2}.\alpha 1 \text{ with } 0.7 \leq \alpha 1 \leq 1.3$$

- 

$$e12 = e22.\frac{\lambda 1}{\lambda 2}.\alpha 2 \text{ with } 0.7 \leq \alpha 2 \leq 1.3$$

- 

$$e13 = e23.\frac{\lambda 1}{\lambda 2}.\alpha 3 \text{ with } 0.7 \leq \alpha 3 \leq 1.3$$

- 

$$e14 = e24.\frac{\lambda 1}{\lambda 2}.\alpha 4 \text{ with } 0.7 \leq \alpha 4 \leq 1.3$$

- 

$$e10 = (e20 + e21 + e22 + e23 + e24) - (e12 + e11 + e13 + e14).$$

5. The method according to the preceding claim, wherein the plurality of first layers of thickness e1i further comprises a first stop layer (15) of thickness e15 under the first lower encapsulation layer (10), and wherein the plurality of second layers of thickness e2i further comprises a second stop layer (25) of thickness e25 under the second lower encapsulation layer (20), with:

- 

$$e15 = e25.\frac{\lambda 1}{\lambda 2}.\alpha 5 \text{ with } 0.7 \leq \alpha 5 \leq 1.3.$$

6. The method according to any one of the preceding claims, wherein the first and second stacks are etched along one same depth h along z to form first and second protruding structures (1, 2), respectively having a first width W1 along a direction x and a first length L1 along a direction y, and a second width W2 along the direction x and a second length L2 along the direction y, said method further comprising, before etching of the first and second stacks (1, 2):

   • Determining the second width W2 and the second length L2 according to the second wavelength λ2,
   • Determining the first width W1 and the first length L1 according to:

      ▪ 

$$W1 = W2.\frac{\lambda 1}{\lambda 2}.\alpha_W \text{ with } 0.7 \leq \alpha_W \leq 1.3$$

      ▪ 

$$L1 = L2.\frac{\lambda 1}{\lambda 2}.\alpha_L \text{ with } 0.7 \leq \alpha_L \leq 1.3.$$

7. The method according to any one of the preceding claims, further comprising a first etching configured to form a first array (120) having a first depth d1 on the first stack carried by the first substrate (110), and independently a second etching configured to form a second array (220) having a second depth d2 on the second stack carried by the second substrate (220).

8. The method according to any one of the preceding claims, wherein the first and second wavelengths λ1, λ2 are chosen in the medium infrared range of between 2 μm and 15 μm, preferably of between 4 μm and 10 μm.

9. A system for manufacturing at least one first optoelectronic device operating at a first wavelength λ1 and a second optoelectronic device operating at a second wavelength λ2 > λ1, the system comprising at least one first substrate (110) carrying a first stack along a direction z comprising a first lower encapsulation layer (10) of thickness e10 along the direction z and a plurality of first layers (11, 12, 13, 14, 15) of thickness e1i (i = 1...n) along the direction z, and a second substrate (210) carrying a second stack along the direction z comprising a second lower encapsulation layer (20) of thickness e20 along the direction z and a plurality of second layers (21, 22, 23, 24, 25) of thickness e2i (i = 1...m) along the direction z, said second layers of thickness e2i having optical functions similar to those of the first layers of thickness e1i, the thicknesses e10, e20 and e1i, e2i verifying the following relationship:

-

$$e1i = e2i.\frac{\lambda1}{\lambda2}.\alpha i \text{ with } 0.7 \leq \alpha i \leq 1.3$$

- 

$$e10 = e20 + \sum_{i=1}^{n} e2i - \sum_{i=1}^{n} e1i$$

such that the first and second stacks have substantially one same height along z.

10. The system according to the preceding claim, wherein the first stack is bordered by first trenches of depth h along the direction z and forms a first protruding structure (1), and the second stack is bordered by second trenches of the same depth h along the direction z and forms a second protruding structure (2).

11. The system according to the preceding claim, wherein the first protruding structure (1) has a first width W1 along a direction x and a first length L1 along a direction y, and the second protruding structure (2) has a second width W2 along the direction x and a second length L2 along the direction y, the first and second widths W1, W2 and the first and second lengths L1, L2 verifying the following relationship:

- 

$$W1 = W2.\frac{\lambda1}{\lambda2}.\alpha_W \text{ with } 0.7 \leq \alpha_W \leq 1.3$$

- 

$$L1 = L2.\frac{\lambda1}{\lambda2}.\alpha_L \text{ with } 0.7 \leq \alpha_L \leq 1.3.$$

12. The system according to any one of claims 9 to 11, wherein the plurality of first layers (11, 12, 13, 14, 15) of thickness e1i comprises at least one first active layer (11) of thickness e11 along z, intended to emit or receive a radiation having the first wavelength $\lambda1$, and a first upper encapsulation layer (12) of thickness e12 along z, and wherein the plurality of second layers (21, 22, 23, 24, 25) of thickness e2i comprises at least one second active layer (21) of thickness e21 along z, intended to emit or receive a radiation having the second wavelength $\lambda2$, and a second upper encapsulation layer (22) of thickness e22 along z, with:

- 

$$e12 = e22.\frac{\lambda1}{\lambda2}.\alpha2 \text{ with } 0.7 \leq \alpha2 \leq 1.3$$

- 

$$e11 = e21.\frac{\lambda1}{\lambda2}.\alpha1 \text{ with } 0.7 \leq \alpha1 \leq 1.3.$$

13. The system according to any one of claims 9 to 12, wherein the first and second substrates (110, 210) are based on silicon and wherein the first and second stacks are based on III-V materials, the first and second stacks respectively comprising first and second optical isolation layers (16, 26) configured to avoid an optical coupling at the wavelengths $\lambda1$ and $\lambda2$ with the first and second substrates (110, 210).

14. The system according to any one of claims 9 to 13, wherein the first and second optoelectronic devices correspond to first and second distributed feedback quantum cascade lasers.

FIG. 1

FIG. 2A

FIG. 2B

FIG. 3A

FIG. 3B

FIG. 4

FIG. 5

E1 ——— Brique Substrat (22 étapes)

E2 ——— Brique DFB (ln) (12 étapes) dont 7 fonction de l

E3 ——— Brique guide Ridge (14 étapes) → Fixe

E4 ——— Brique contact Inf (10 étapes) → Fixe

E5 ——— Brique contact Sup (10 étapes) → Fixe

E6 ——— Brique métallisation (16 étapes) → Fixe

FIG. 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• US 2005030997 A